# EUROPÄISCHE PATENTSCHRIFT

(11) **EP 4 385 100 B1**
(45) Veröffentlichungstag und Bekanntmachung des Hinweises auf die Patenterteilung: **29.01.2025**
(21) Anmeldenummer: 23793994.7
(22) Anmeldetag: 09.10.2023
(51) Int. Cl.: H01R 12/70, H01R 12/73, H01R 13/518, H01R 13/514, H05K 1/00, H05K 5/00

(54) **VORRICHTUNG UND VERFAHREN ZUR VERBINDUNG ZWEIER LEITERKARTENSTECKVERBINDER ÜBER EIN KOPPELELEMENT**
DEVICE AND METHOD FOR CONNECTING TWO PRINTED CIRCUIT BOARD PLUG CONNECTORS VIA A COUPLING ELEMENT
DISPOSITIF ET PROCÉDÉ DE CONNEXION DE DEUX CONNECTEURS ENFICHABLES DE CARTE DE CIRCUIT IMPRIMÉ PAR L'INTERMÉDIAIRE D'UN ÉLÉMENT DE COUPLAGE

(30) Priorität: 28.10.2022 DE 102022128681
(43) Veröffentlichungstag der Anmeldung: 19.06.2024
(73) Patentinhaber: HARTING Electric Stiftung & Co. KG, 32339 Espelkamp (DE)
(72) Erfinder: WOLF, Torsten, 32339 Espelkamp (DE)
(86) Internationale Anmeldenummer: PCT/DE2023/100748
(87) Internationale Veröffentlichungsnummer: WO 2024/088470

(56) Entgegenhaltungen:
- US-A1- 2022 224 031
- US-A1- 2022 302 648

## Beschreibung

Die Erfindung geht aus von einer Vorrichtung zur reversiblen mechanischen Verbindung zweier Leiterkartensteckverbinder über ein Koppelelement nach der Gattung des unabhängigen Anspruchs 1.

Desweiteren geht die Erfindung aus von einem Verfahren zur reversiblen mechanischen Verbindung zweier Leiterkartensteckverbinder über das Koppelelement mittels einer Vorrichtung gemäß dem unabhängigen Anspruch 1.

Derartige Koppelelemente werden benötigt, um jeweils zwei Leiterkartensteckverbinder zur gemeinsamen, besonders handlichen Montage auf einer Leiterkarte mechanisch miteinander zu verbinden. Die Leiterkartensteckverbinder sind dazu vorgesehen, einerseits mit ihren Steckkontakten an Leiterbahnen der Leiterkarte angeschlossen zu werden und anderseits steckseitig mit Gegenkontakten von Gegensteckverbindern zu kontaktieren. Bei den Gegensteckverbindern kann es sich um Leiterkartengegensteckverbinder handeln, welche auf einer weiteren Leiterkarte montiert werden.

Die Leiterkartensteckverbinder können jeweils aus mehreren einzelnen Leiterkartensteckverbindermodulen zusammengesetzt sein und/oder diese aufweisen. Die Leiterkartensteckverbindermodule können dazu jeweils auf zumindest einem Verbinder aufgereiht und daran reversibel befestigt sein.

### Stand der Technik

Die Druckschrift DE 10 2019 109 471 A1 offenbart eine Anordnung, bestehend aus einem ersten modularen Leiterkartensteckverbinder und zumindest einem zweiten modularen Leiterkartensteckverbinder, zur gemeinsamen Montage auf einer Leiterkarte. Die Leiterkartensteckverbinder sind jeweils aus mehreren einzelnen Steckverbindermodulen zusammengesetzt. Die Steckverbindermodule sind jeweils auf zumindest einem Verbinder aufgereiht und daran reversibel befestigt. Der erste Leiterkartensteckverbinder und der zweite Leiterkartensteckverbinder sind über ein Koppelelement reversibel miteinander verbunden.

Nachteilig bei diesem Stand der Technik ist, dass die Verbindung zweier Leiterkartensteckverbinder über das Koppelelement unerwünscht aufwändig ist und händisches Geschick verlangt, da jeder der beiden Leiterkartensteckverbinder händisch an dem Koppelement befestigt werden muss, was in der Regel eine exakte Positionierung verlangt. Eine automatisierte Verbindung mittels Robotertechnik wäre demnach, wenn überhaupt möglich, dann äußerst aufwändig.

Das Deutsche Patent- und Markenamt hat in der Prioritätsanmeldung zur vorliegenden Anmeldung den folgenden Stand der Technik recherchiert:
DE 10 2017 119 287 A1, DE 10 2019 109 471 A1,
DE 10 2019 125 797 A1 und DE 20 2004 007 857 U1.

Die Druckschrift US 2022/302648 A1 offenbart ein Verfahren zum Verbinden von zwei Steckverbindern und einen Satz Steckverbinder. Jeder der beiden Steckverbinder umfasst einen Hauptkörper, der so konfiguriert ist, dass er mehrere elektrische Drähte hält, und ein Paar Druckelemente, die von beiden Seiten des Hauptkörpers entlang einer ersten Richtung hervorstehen. Beim Zusammenstecken des Steckverbinders werden die beiden Steckverbinder jeweils in zugeordnete Buchsensteckverbinder in einem Zustand eingeführt, in dem die beiden Steckverbinder mechanisch gekoppelt oder durch eine Spannvorrichtung an eine relative Positionsbeziehung gebunden sind. In einer Position, in der sich das Paar von Druckelementen in einem der beiden Steckverbindungen befindet zwei Steckverbinder werden von dem Paar Druckelemente im anderen der beiden Steckverbinder entlang einer zweiten Richtung orthogonal zur ersten Richtung verschoben.

Die Druckschrift US 2022/224031 A1 offenbart eine Anordnung bestehend einem ersten modularen Leiterplattensteckverbinder und zumindest einem zweiten modularen Leiterplattensteckverbinder zur Montage auf einer Leiterplatte, wobei die Leiterplattensteckverbinder jeweils aus mehreren einzelnen Steckverbindermodulen zusammengesetzt sind und die Steckverbindermodule jeweils auf zumindest einem Verbinder aufgereiht und daran reversibel befestigt sind, wobei der erste Leiterplattensteckverbinders und der zumindest zweite Leiterplattensteckverbinders über ein Koppelelement miteinander reversibel verbunden sind.

### Aufgabenstellung

Die Aufgabe der Erfindung besteht darin, eine Vorrichtung anzugeben, die dazu geeignet ist, den Aufwand zu verringern, der nötig ist, um zumindest zwei Leiterkartensteckverbinder über ein oder mehrere Koppelelemente reversibel mechanisch miteinander zu verbinden. Eine zusätzliche Aufgabe besteht darin, ein Verfahren anzugeben, mit dem es möglich ist, die vorgenannte Verbindung mittels der vorgenannten Vorrichtung durchzuführen.

Die Aufgabe wird durch den jeweiligen Gegenstand der unabhängigen Ansprüche gelöst.

Eine Vorrichtung dient zur reversiblen gegenseitigen mechanischen Verbindung zumindest zweier Leiterkartensteckverbinder über zumindest ein Koppelelement.

Die Vorrichtung besitzt zumindest eine Einführöffnung zum Einführen des zumindest einen Koppelelements in einer Einführrichtung und weiterhin zumindest zwei Einschuböffnungen zum Einschieben zumindest zweier Leiterkartensteckverbinder in einer Einschubrichtung. Dabei ist die zumindest eine Einführöffnung mit zwei der Einschuböffnungen verbunden, um eine mechanische Fixierung des mindestens einen Koppelelements an jeweils zwei der Leiterkartensteckverbinder zu ermöglichen.

Vorteilhafte Ausgestaltungen der Erfindung sind in den Unteransprüchen und der folgenden Beschreibung angegeben.

Die Erfindung hat den Vorteil, dass mittels dieser Vorrichtung die Verbindung der Leiterkartensteckverbinder erheblich erleichtert wird.

Die Erfindung hat den besonderen Vorteil, dass zwei, aber auch mehr als zwei Leiterkartensteckverbinder miteinander verbunden werden können, so dass sie wesentlich einfacher auf einer Leiterkarte montiert werden kann als mehrere einzelne Leiterkartesteckverbinder. Zudem kann jeder der Leiterkartensteckverbinder, wie bereits erwähnt, mehrere in einer Reihe angeordnete Leiterkartensteckverbindermodule aufweisen. Die einzelnen Leiterkartensteckverbindermodule können verschieden Funktionen besitzen und sind individuell zusammenstellbar. Beispielsweise ist hierzu auch in der Druckschrift DE 10 2019 125 797 A1 eine geeignete Montagevorrichtung zum Verbinden der Leiterkartensteckverbindermodule eines Leiterkartensteckverbinders mit einem Verbindungselement offenbart. Durch die vorliegende Erfindung ist es nun auch mit sehr geringem Aufwand möglich, diese Module durch gegenseitige Verbindung mehrerer Leiterkartensteckverbinder (die jeweils mehrere Module besitzen können) zu einem flächigen Array anzuordnen, und so einen Array mit Zeilen und Spalten aus Steckverbindermodulen mit nur geringem Aufwand herzustellen und diesen mit ebenfalls nur geringem Aufwand als eine kompakte Einheit auf einer Leiterklarte zu montieren.

Ein besonders großer Vorteil besteht in der Erhöhung des Grades der Automatisierbarkeit. Schließlich ist es beispielsweise - insbesondere für einen Roboter - viel einfacher, Leiterkartensteckverbinder in dafür vorgesehene Einschuböffnungen, die insbesondere auch noch mit Einführschrägen versehen sein können, einzuschieben und mit einem zuvor in die Vorrichtung eingefügten Koppelelement zu verrasten und/oder zu verklemmen, als diesen Vorgang rein manuell - händisch oder gar mit Roboterarmen und entsprechender Sensorik - durchzuführen.

In einer bevorzugten Ausgestaltung können die Einführrichtung und die Einschubrichtung rechtwinklig zueinander verlaufen. Dies ist besonders vorteilhaft, weil sich die Befestigung, z. B. Verklemmung oder Verrastung, an dem Koppelelement auf diese Weise am einfachsten gestaltet. Beispielsweise können die Rastvorrichtungen und/oder Klemmvorrichtungen am jeweiligen Koppelelement und an den Leiterkartensteckverbindern dadurch sehr unaufwändig ausgeführt sein.

In einer bevorzugten Ausgestaltung weist die Vorrichtung zumindest zwei Einführöffnungen auf, nämlich zumindest eine schmale Einführöffnung und zumindest eine breite Einführöffnung. Die zumindest eine schmale Einführöffnung ist zum Einführen zumindest eines schmalen Koppelelements eingerichtet. Sie ist an einer ersten Seitenfläche der Vorrichtung angeordnet. Die zumindest eine breite Einführöffnung ist zum Einführen zumindest eines breiten Koppelelements eingerichtet und ist an einer zweiten Seitenfläche der Vorrichtung angeordnet. Die erste und die zweite Seitenfläche können einander gegenüberliegen.

Weiterhin kann die Vorrichtung zumindest vier Einschuböffnungen aufweisen, nämlich zumindest zwei schmale Einschuböffnungen und zumindest zwei breite Einschuböffnungen.

Die breiten Einschuböffnungen sind an der ersten Seitenfläche der Vorrichtung angeordnet und stehen mit der schmalen Einführöffnung in Verbindung. Jede der breiten Einschuböffnungen ist zum Einschieben eines breiten Leiterkartensteckverbinders eingerichtet. Die schmalen Einschuböffnungen sind an einer zweiten Seitenfläche der Vorrichtung angeordnet und stehen mit der breiten Einführöffnung in Verbindung. Jede der schmalen Einschuböffnungen ist zum Einschieben eines schmalen Leiterkartensteckverbinders eingerichtet.

In einer vorteilhaften Weiterbildung besitzt die Vorrichtung eine Basisplatte. Dies ist besonders vorteilhaft, weil die Vorrichtung mit dieser Basisplatte stabil auf eine flache Montageeinrichtung wie z. B. eine Werkbank, einen Schreibtisch o. ä. gestellt werden kann.

Weiterhin kann die Vorrichtung einen Führungskörper aufweisen, welcher auf die Basisplatte aufbaut. Die besagte erste Seitenfläche und die besagte zweite Seitenfläche sind dann Bestandteil dieses Führungskörpers. Der Führungskörper kann bevorzugt eine im wesentlichen quaderförmige Grundform besitzen. Die erste und die zweite Seitenfläche können Bestandteil dieses Führungskörpers sein. Insbesondere können die erste und die Zweite Seitenfläche einander, bevorzugt parallel, gegenüberliegen. Dies ist besonders vorteilhaft, weil die Vorrichtung auf diese Weise besonders kompakt aufgebaut ist. Die bevorzugt quaderförmige Grundform besitzt an einer der Basisplatte abgewandten Seite eine Deckenfläche, welche idealerweise parallel zu Basisplatte verläuft.

Die Einschuböffnungen, d. h. sowohl die schmalen als auch die breiten Einschuböffnungen, sind zur Deckenfläche hin geöffnet. Zudem können sie an Ihren deckenseitigen Öffnungen Einführschrägen aufweisen. Dies ermöglicht und erleichtert das Einschieben, insbesondere das automatisierte Einschieben, der jeweiligen Leiterkartensteckverbinder.

In einer bevorzugten Ausgestaltung sind beiden breiten Einschuböffnungen nicht nur zur Deckenfläche hin, sondern zudem auch zur ersten Seitenfläche hin geöffnet. Dies hat den Vorteil der Material- und Platzersparnis sowie geringerer Reibung und besserer Handhabbarkeit. Auch wird die Entnahme der breiten Leiterkartensteckverbinder, insbesondere der miteinander verbundenen breiten Leiterkartensteckverbinder, dadurch erleichtert oder - je nach Bauform - überhaupt erst ermöglicht.

In einer weiteren bevorzugten Ausgestaltung sind die schmalen Einschuböffnungen nicht nur zur Deckenfläche hin, sondern zudem auch zur zweiten Seitenfläche hin geöffnet. Dies hat den Vorteil der Material- und Platzersparnis sowie geringerer Reibung und besserer Handhabbarkeit. Auch wird die Entnahme der schmalen Leiterkartensteckverbinder, insbesondere der miteinander verbundenen schmalen Leiterkartensteckverbinder dadurch erleichtert oder - je nach Bauform - überhaupt erst ermöglicht.

Die Vorrichtung ist bevorzugt dazu eingerichtet, an der ersten Seitenfläche ein schmales Koppelelement in die schmale Einführöffnung einzuführen. Insbesondere ist die Vorrichtung dazu eingerichtet, in die z. B. beiden breiten Einschuböffnungen je einen breiten Leiterkartensteckverbinder zur jeweiligen Befestigung an dem schmalen Koppelelement einzuschieben, um so diese beiden breiten Leiterkartensteckverbinder über das schmale Koppelelement mechanisch miteinander zu verbinden.

Bevorzugt ist die Vorrichtung dazu eingerichtet, an der zweiten Seitenfläche in die breite Einführöffnung ein breites Koppelelement einzuführen und in die z. B. beiden schmalen Einschuböffnungen je einen schmalen Leiterkartensteckverbinder zur jeweiligen Befestigung an dem breiten Koppelelement einzuschieben, um diese beiden schmalen Steckverbinder über das breite Koppelelement mechanisch miteinander zu verbinden.

Ein Verfahren zur reversiblen gegenseitigen mechanischen Verbindung zumindest zweier Leiterkartensteckverbinder über zumindest ein Koppelelement zu zumindest einem Leiterkartensteckverbinderpaar mittels einer Vorrichtung der vorgenannten Art weist die folgenden Verfahrensschritte auf:
A. Einführen eines breiten Koppelements in eine breite Einführöffnung und/oder eines schmalen Koppelelements in eine schmale Einführöffnung der Vorrichtung;
B. Einschieben zweier schmaler Leiterkartensteckverbinder in jeweils eine der beiden schmalen Einschuböffnungen und/oder zweier breiter Leiterkartensteckverbinder in je eine der beiden breiten Einschuböffnungen der Vorrichtung;
C. gemeinsames reversibles Befestigen, z.B. durch Verrasten oder Verklemmen, der beiden schmalen Leiterkartensteckverbinder an dem breiten Koppelelement und dadurch Verbinden zu einem schmalen Leiterkartensteckverbinderpaar und/oder gemeinsames reversibles Befestigen, z.B. durch Verrasten oder Verklemmen, der beiden breiten Leiterkartensteckverbinder an dem schmalen Koppelelement und dadurch Verbinden zu einem breiten Leiterkartensteckverbinderpaar;
D. Entnahme des schmalen und/oder breiten Leiterkartensteckverbinderpaars aus der jeweiligen schmalen und/oder breiten Einschuböffnung.

Bevorzugt kann die vorgenannte Entnahme in Verfahrensschritt D. dabei parallel zur Grundplatte erfolgen.

Auf diese Weise können die Leiterkartensteckverbinder jeweils zumindest einseitig mechanisch zu einem Steckverbinderpaar miteinander verbunden werden.

Insbesondere besitzen die besagten schmalen und breiten Leiterkartensteckverbinder eine längliche Grundform mit zwei Schmalseiten und zwei Längsseiten. Die Schmalseiten der breiten Leiterkartensteckverbinder sind zwar breiter als die der schmalen Leiterkartensteckverbinder, aber immer noch wesentlich schmaler als ihre Längsseiten.

Die schmalen und die breiten Leiterkartesteckverbinder können vorteilhafterweise miteinander steckbar sein. Dementsprechend korrespondieren dann auch ihre Längen. Die schmalen Leiterkartensteckverbinder können z. B. geometrisch in die breiten Leiterkartensteckverbinder gesteckt werden. Beispielsweise können die breiten Leiterkartensteckverbinder Pinkontakte ("male") und die schmalen Leiterkartensteckverbinder Buchsenkontakte ("female") besitzen. Insbesondere können die breiten Leiterkartensteckverbinder Leiterkartensteckverbindermodule mit Pinkontakten ("male") und die schmalen Leiterkartensteckverbinder Leiterkartensteckverbindermodule mit Buchsenkontakten ("female") besitzen. Aufgrund ihrer Geometrie ist es selbstverständlich vorteilhaft, dass die beiden breiten Leiterkartensteckverbinder miteinander über das zumindest eine schmale Koppelelement und die beiden schmalen Leiterkartensteckverbinder über das zumindest eine breite Koppelelement miteinander jeweils zu einem entsprechenden Leiterkartensteckverbinderpaar verbunden werden.

Insbesondere ist auch mit einer Vorrichtung, welche genau zwei schmale und genau zwei breite Einschuböffnungen sowie genau eine breite und eine schmale Einführöffnung besitzt, die Verbindung von mehr als zwei Leiterkartensteckverbindern zu einem Array möglich. Nach der Entnahme kann das bereits verbundene Leiterkartensteckverbinderpaar schließlich erneut, aber versetzt, in die Vorrichtung eingesteckt werden, so dass einer der beiden Leiterkartensteckverbinder wieder mit einem weiteren Leiterkartensteckverbinder über ein zusätzliches Koppelelement verbunden wird. Dann sind bereits drei Leiterkartensteckverbinder miteinander mechanisch verbunden. Dieser Vorgang kann selbstverständlich so lange wiederholt werden, bis dass am Ende der gewünschte Array entstanden ist.

Weiterhin kann auch eine Vorrichtung mit mehr als einer Einführöffnung sowie mit mehr als zwei schmalen und/oder breiten Einstecköffnungen versehen sein, wobei die Einstecköffnungen jeweils an der ersten und/oder zweiten Seitenfläche in äquidistanten Abständen zueinander angeordnet sind. Damit erhöht sich zwar der Materialaufwand und auch der Herstellungsaufwand der Vorrichtung, jedoch reduziert sich der Verfahrensaufwand bei der mechanischen Verbindung ganzer Arrays von Leiterkartensteckverbindern, weil auf diese Weise auch mehr als zwei Leiterkartensteckverbinder gleichzeitig miteinander verbunden werden können. Für einen konkreten Anwendungsfall kann also eine optimale Anzahl der Einstecköffnungen ermittelt und dem Kunden eine geeignete Vorrichtung, insbesondere zur automatisierten Verbindung, angeboten werden. Als Herstellungsverfahren bietet sich für Kleinserien zur Befriedigung individueller Kundenwünsche ein additives Verfahren, wie z. B. der 3D-Druck, an. Für Großauflagen kommt dagegen als bevorzugtes Herstellungsverfahren auch ein Spritzgussverfahren In Frage. In der Regel kann die Vorrichtung aus Kostengründen jedenfalls aus Kunststoff bestehen, um den Vorteil der preiswerten und einfachen Herstellung zu nutzen.

Für die händische Bedienung ist es vorteilhaft, wenn die Vorrichtung einteilig ausgeführt ist. Es kann aber auch Sinn ergeben, die Vorrichtung mehrteilig auszuführen, beispielsweise wenn die Verbindung automatisch von einem Roboter o. ä. durchgeführt werden soll, damit die verschiedenen Teile örtlich getrennt an geeigneten Positionen in der entsprechenden Anlage anzuordnen sind. Dann können insbesondere die breiten Einschuböffnungen gemeinsam mit der schmalen Einführöffnung zu einem ersten Teil der Vorrichtung gehören und die schmalen Einschuböffnungen können gemeinsam mit der breiten Einführöffnung zu einem zweiten Teil der Vorrichtung gehören und zur separaten Bestückung unabhängig voneinander in der Produktionsanlage angeordnet sein.

Gemäß dem vorgenannten Verfahren sind die Leiterkartensteckverbinder jedes Leiterkartensteckverbinderpaars zunächst jedoch nur an je einer Schmalseite miteinander verbunden. Das bereits einseitig verbundene Leiterkartensteckverbinderpaar (oder der Array) kann aber auch um 180° gedreht und erneut in die zuvor mit einem weiteren Koppelelement versehenen Vorrichtung gesteckt werden, um Leiterkartensteckverbinder des Leiterkartensteckverbinderpaars in vergleichbarer Weise auch an ihrer anderen Schmalseite mechanisch miteinander zu verbinden.

Insbesondere kann das Verfahren daher zusätzlich noch die folgenden Verfahrensschritte aufweisen:
E. Einführen eines weiteren schmalen Koppelements in die schmale Einführöffnung und/oder eines weiteren breiten Koppelelements in die breite Einführöffnung der Vorrichtung;
F. Drehen der breiten und/oder schmalen Leiterkartensteckverbinder um 180°;
G. gemeinsames Einschieben des breiten und/oder des schmalen Leiterkartensteckverbinderpaars mit der dem an ihnen bereits befestigten Koppelelement abgewandten Seite voran in die breiten und/oder schmalen Einschuböffnungen;
H. zusätzliches mechanisches gegenseitiges Verbinden der beiden schmalen und/oder der beiden breiten Leiterkartensteckverbinder über das jeweilige weitere Koppelelement an ihrer zuvor noch unverbundenen Seite;
I. erneute gemeinsame Entnahme des breiten und/oder des schmalen Leiterkartensteckverbinderpaars aus den schmalen und/oder breiten Einschuböffnungen der Vorrichtung.

Bevorzugt kann die vorgenannte Entnahme in Verfahrensschritt I. dabei parallel zur Grundplatte erfolgen.

Soll, wie oben beschrieben, ein ganzer Array bestehend aus mehr als zwei Leiterkartensteckverbindern miteinander verbunden werden, so können diese Leiterkartensteckverbinder vorteilhafterweise erst an ihrer ersten Seite/Schmalseite, paarweise miteinander verbunden werden und dann komplett um 180° gedreht und an ihrer zweiten Seite/Schmalseite miteinander verbunden werden.

### Ausführungsbeispiel

Ein Ausführungsbeispiel der Erfindung ist in den Zeichnungen dargestellt und wird im Folgenden näher erläutert. Es zeigen:
- Fig. 1a, b: eine Vorrichtung aus zwei verschiedenen Blickwinkeln;
- Fig. 2a, b: die Vorrichtung mit eingeführten Koppelelementen;
- Fig. 3a - c: die Vorrichtung mit eingeschobenen Leiterkartensteckverbindern.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein. Richtungsangaben wie beispielsweise "links", "rechts", "oben" und "unten" sind mit Bezug auf die jeweilige Figur zu verstehen und können in den einzelnen Darstellungen gegenüber dem dargestellten Objekt variieren.

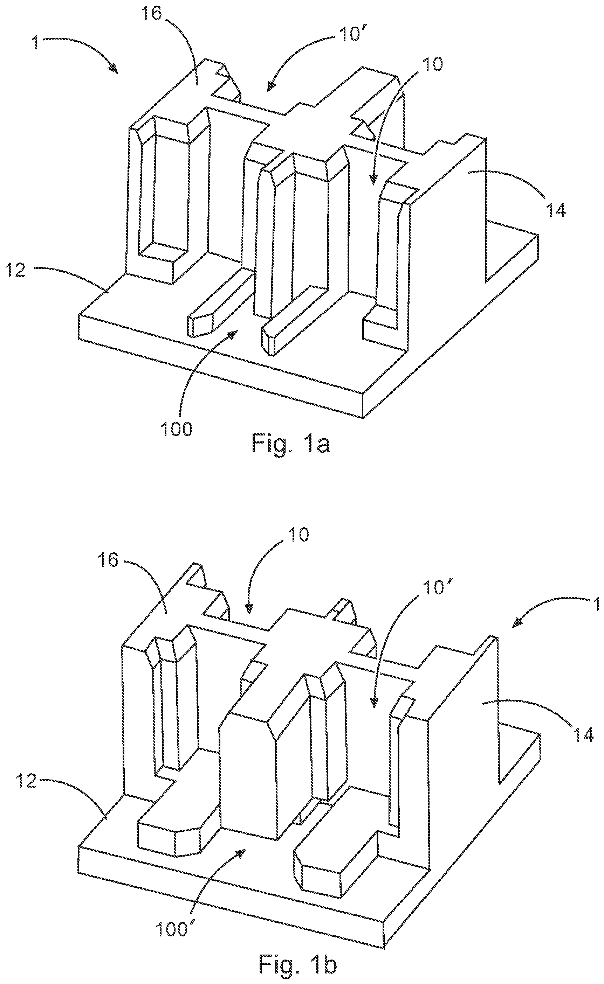

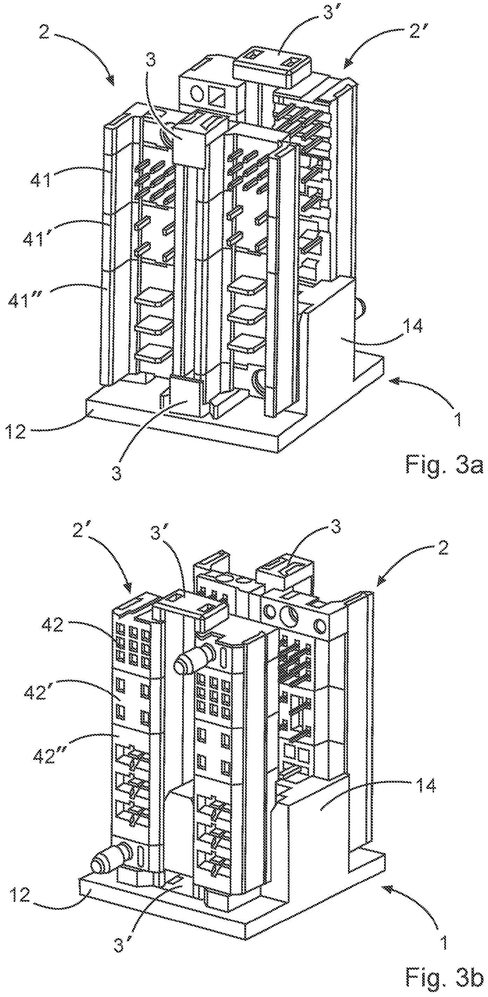

Die Fig. 1a und Fig. 1b zeigen eine Vorrichtung 1 zur reversiblen gegenseitigen mechanischen Verbindung zweier Leiterkartensteckverbinder 2, 2', welche in den Fig.3a - c gezeigt sind. Die Fig. 1a zeigt die Vorrichtung mit Blick auf eine erste Seitenfläche der Vorrichtung 1, die Fig. 1b mit Blick auf eine zweite Seitenfläche dieser Vorrichtung 1.

Die Vorrichtung 1 ist einstückig ausgeführt und besitzt eine Basisplatte 12 sowie einen auf die Basisplatte 12 aufbauenden Führungskörper 14. Der Führungskörper 14 besitzt eine im Wesentlichen quaderförmige Grundform, in welche beidseitig, d. h. an den beiden einander gegenüberliegenden, parallelen Seitenflächen jeweils zwei, also insgesamt vier, Einschuböffnungen 10, 10' angeordnet sind. Weiterhin sind in der Nähe der Basisplatte 12 beidseitig je eine, also insgesamt zwei, Einführöffnungen 100, 100' angeordnet. Genauer gesagt sind an der ersten Seitenfläche zwei breite Einschuböffnungen 10 und an der zweiten Seitenfläche zwei schmale Einschuböffnungen 10' angeordnet. Die erste und die zweite Seitenfläche sind dabei einander gegenüberliegende Seitenflächen des im wesentlichen quaderförmigen Führungskörpers 14 und sind aus Übersichtlichkeitsgründen nicht näher bezeichnet. Gegenüberliegend der Basisplatte besitzt der Führungskörper eine Deckenfläche 16. Die Einschuböffnungen 10, 10' sind zu der jeweiligen Seitenfläche, an der sie angeordnet sind, hin geöffnet. Zudem sind die Einschuböffnungen 10, 10' zur Deckenfläche 16 hin geöffnet und an dieser Öffnung mit Einführschrägen versehen.

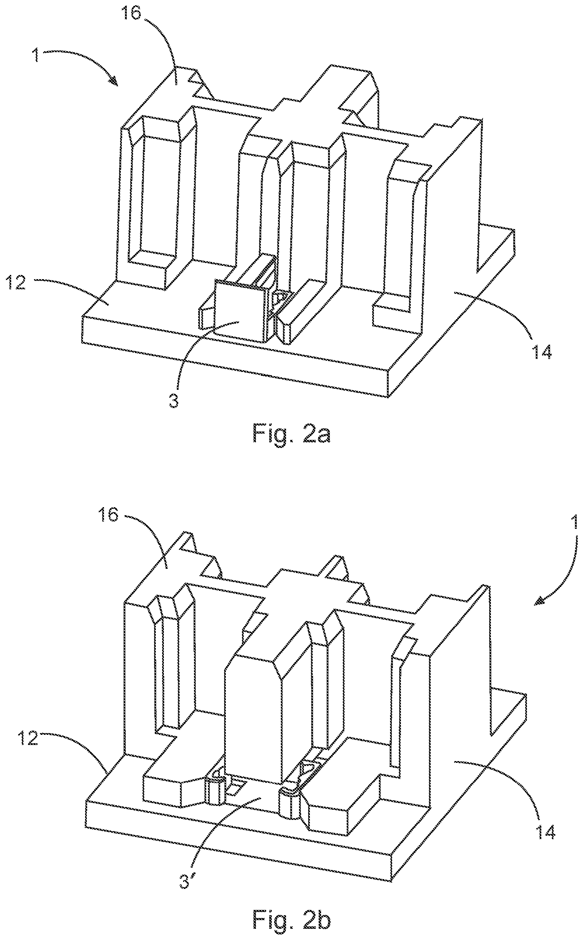

Die Fig. 2a und 2b zeigen die Vorrichtung 1 mit darin beidseitig eingeführten Koppelelementen 3, 3', nämlich einem schmalen 3 und einem breiten 3' Koppelelement mit Blick auf die erste bzw. zweite Seitenfläche. Es ist in Verbindung mit der vorangegangenen Darstellung leicht erkennbar, dass die Koppelemente 3, 3' je in einer der vorgenannten Einführöffnungen 100, 100' angeordnet sind, nämlich das schmale Koppelelement 3 in der schmalen Einführöffnung 100 und das breite Koppelelement 3' in der breiten Einführöffnung 100'.

Die Fig. 3a-c zeigen die vorgenannte Anordnung zusammen mit jeweils zwei, also insgesamt vier, beidseitig in die jeweiligen Einschuböffnungen 10, 10' eingeschobenen Leiterkartensteckverbindern 2, 2', nämlich zwei breiten Leiterkartensteckverbindern 2 und zwei schmalen Leiterkartensteckverbindern 2'.

Die beiden breiten Leiterkartensteckverbinder 2 sind in den breiten Einschuböffnungen 10 der Vorrichtung 1 angeordnet und die beiden schmalen Leiterkartensteckverbinder 2' sind in den schmalen Einschuböffnungen 10' der Vorrichtung 1 angeordnet, indem sie zuvor jeweils, in der Zeichnung von oben kommend, in die jeweiligen Einschuböffnungen 10, 10' eingeschoben wurden. Dabei werden sie gemeinsam über das eingefügte Koppelelement 3, 3' miteinander verbunden, indem sie endseitig jeweils am Koppelelement 3, 3' verklemmen und/oder verrasten. Daraufhin können sie insbesondere parallel zur Basisplatte 12 der Vorrichtung 1 entnommen werden.

Es ist offensichtlich, dass die Leiterkartensteckverbinder 2, 2' nicht nur an einer, sondern sogar an zwei einander gegenüberliegenden Schmalseiten mit je einem Koppelelement 3, 3' versehen sind. Dazu wurden sie zuvor einzeln in die dazugehörigen Einschuböffnungen 10, 10' eingeschoben um so je über ein erstes schmales bzw. breites Koppelelement 3, 3' aneinander befestigt zu werden. Dann wurden sie um 180° gedreht und erneut in die Einschuböffnungen 10, 10' eingeschoben um auch an ihrer dem bereits daran befestigten jeweils ersten Koppelelement 3, 3' gegenüberliegenden zweiten Schmalseite über ein weiteres, zwischenzeitig in die jeweilige Einführöffnung 100, 100' eingeführtes Koppelelement 3, 3' zusätzlich aneinander befestigt zu werden.

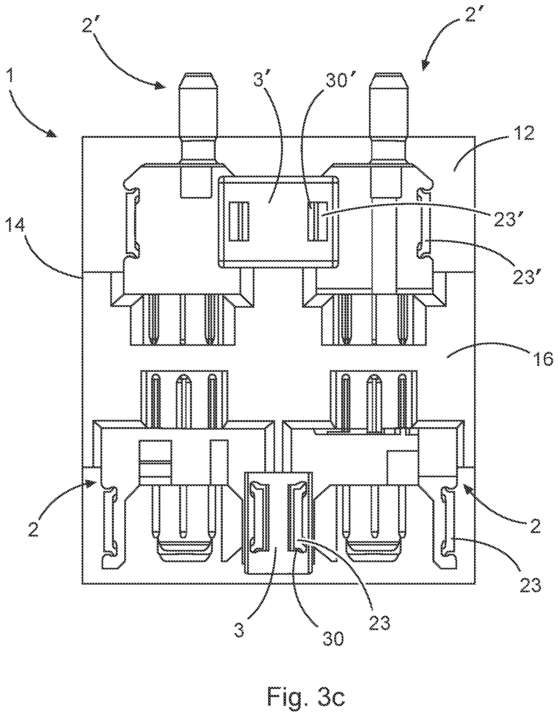

Zur Befestigung können die Leiterkartensteckverbinder 2, 2' je zwei in der Fig. 3c gezeigte Rast- und/oder Klemmnasen 23, 23' besitzen. Die Koppelelemente 3, 3' können je ein Rast- und/oder Klemmfenster 30, 30' besitzen, welches damit reversibel befestigend zusammenwirkt.

Falls es gewünscht ist, einen Array aus mehr als zwei Leiterkartensteckverbindern 2, 2' zu bilden, können die beiden, nun jeweils bereits zu einem Leiterkartensteckverbinderpaar verbundenen, Leiterkartensteckverbinder 2, 2' um einen Steckplatz / eine Einschubausnehmung 10, 10' verschoben und erneut in die Vorrichtung 1 eingeführt und in der vorgenannten Weise mit einem weiteren Leiterkartensteckverbinder 2, 2' mechanisch verbunden werden. Dieser Vorgang kann solange wiederholt werden, bis ein Array der gewünschten Größe entstanden ist.

Bei den breiten Leiterkartensteckverbindern 2 handelt es sich um männliche ("male") Steckverbinder, d.h. sie besitzen z.B. Stiftkontakte.

Bei den schmalen Leiterkartensteckverbindern 2' handelt es sich um weibliche ("female") Steckverbinder, d.h. sie besitzen Buchsenkontakte.

Weiterhin handelt es sich bei den Steckverbindern um modulare
Leiterkartensteckverbinder 2, 2', d. h. sie weisen jeweils mehrere jeweils in einer Reihe angeordnete
Leiterkartensteckverbindermodule 41, 41, 41", 42, 42', 42" auf. Die männlichen Leiterkartensteckverbinder 2 besitzen männliche
Leiterkartensteckverbindermodule 41, 41', 41", die weiblichen
Leiterkartensteckverbinder 2' besitzen weibliche
Leiterkartensteckverbindermodule 42, 42', 42".

Die männlichen Leiterkartensteckverbinder 2 sind zu den weiblichen Leiterkartensteckverbindern 2' korrespondierend aufgebaut und sind mit ihnen steckbar. Somit können sowohl Leiterkartensteckverbinderpaare als auch ganze Arrays individuell und komfortabel zusammenstellbarer Steckverbindermodule auf zwei Leiterkarten in Form von Leiterkartensteckverbindern und Leiterkartengegensteckverbindern zur elektrischen Verbindung der Leiterkarten auf besonders komfortable Weise zusammengestellt werden.

### Bezugszeichenliste

- 1: Vorrichtung
- 12: Basisplatte
- 14: Führungskörper
- 16: Deckenfläche
- 10, 10': breite, schmale Einschuböffnung
- 100, 100': schmale, breite Einführöffnung

- 2, 2': männliche, weibliche Leiterkartensteckverbinder
- 23, 23': Rast und/oder Klemmnasen

- 3, 3': schmale, breite Koppelelemente
- 30, 30': Rast- und/oder Klemmfenster

- 41, 41', 41": männliche Leiterkartensteckverbindermodule
- 42, 42', 42": weibliche Leiterkartensteckverbindermodule

## Patentansprüche

1. Vorrichtung (1) **dadurch gekennzeichnet, dass** die Vorrichtung zur reversiblen gegenseitigen mechanischen
Verbindung zumindest zweier Leiterkartensteckverbinder (2, 2') über zumindest ein Koppelelement (3, 3') dient,
wobei die Vorrichtung (1) zumindest eine Einführöffnung (100, 100') zum Einführen des zumindest einen Koppelelements (3, 3') in einer Einführrichtung besitzt, und
wobei die Vorrichtung (1) weiterhin zumindest zwei Einschuböffnungen (10, 10') zum Einschieben der zumindest zwei Leiterkartensteckverbinder (2, 2') in einer Einschubrichtung aufweist, wobei die mindestens eine Einführöffnung (100, 100') mit zwei der Einschuböffnungen (10, 10') verbunden ist, um eine mechanische Fixierung des mindestens einen Koppelelements (3, 3') an jeweils zwei der Leiterkartensteckverbinder (2, 2') zu ermöglichen.

2. Vorrichtung (1) gemäß Anspruch 1, wobei die Einführrichtung und die Einschubrichtung rechtwinklig zueinander verlaufen.

3. Vorrichtung (1) gemäß einem der vorstehenden Ansprüche, wobei die Vorrichtung (1) einteilig ausgeführt ist.

4. Vorrichtung (1) gemäß einem der Ansprüche 1 bis 2, wobei die Vorrichtung (1) mehrteilig ausgeführt ist.

5. Vorrichtung (1) gemäß einem der vorstehenden Ansprüche, wobei die Vorrichtung (1) aus Kunststoff besteht.

6. Vorrichtung (1) gemäß Anspruch 5, wobei die Vorrichtung (1) in einem additiven Fertigungsverfahren, wie z. B. 3D-Druck, hergestellt ist.

7. Vorrichtung (1) gemäß Anspruch 5, wobei die Vorrichtung (1) in einem Spritzgussverfahren hergestellt ist.

8. Vorrichtung (1) gemäß einem der vorstehenden Ansprüche, wobei die Vorrichtung (1) mindestens zwei Einführöffnungen (100, 100') aufweist, nämlich mindestens eine zur Einführung eines schmalen Koppelelements (3) eingerichtete schmale Einführöffnung (100), die an einer ersten Seitenfläche der Vorrichtung (1) angeordnet ist, und weiterhin mindestens eine zum Einführen eines breiten Koppelelements (3') eingerichtete breite Einführöffnung (100'), welche an einer zweiten Seitenfläche der Vorrichtung (1) angeordnet ist.

9. Vorrichtung (1) gemäß Anspruch 8, wobei die Vorrichtung (1) mindestens vier Einschuböffnungen (10, 10') aufweist, nämlich mindestens zwei breite Einschuböffnungen (10), die an der ersten Seitenfläche angeordnet sind und mit der mindestens einen schmalen Einführöffnung (100) in Verbindung stehen, und weiterhin mindestens zwei schmale Einschuböffnungen (10'), die an der zweiten Seitenfläche angeordnet sind und mit der mindestens einen schmalen Einführöffnung (100') in Verbindung stehen.

10. Vorrichtung (1) gemäß Anspruch 9, wobei die Vorrichtung (1) eine Basisplatte (12) und einen Führungskörper (14) besitzt, wobei der Führungskörper (14) auf die Basisplatte (12) aufbaut, und wobei die besagte erste Seitenfläche und die besagte zweite Seitenfläche Bestandteil des Führungskörpers (14) sind.

11. Vorrichtung (1) gemäß Anspruch 10, wobei der Führungskörper (14) eine im wesentlichen quaderförmige Grundform besitzt.

12. Vorrichtung (1) gemäß einem der Ansprüche 10 bis 11, wobei die Einschuböffnungen (10, 10') zu einer, der Basisplatte (12) abgewandten Deckenfläche (16) des Führungskörpers (14) hin, also deckenseitig, geöffnet sind.

13. Vorrichtung (1) gemäß Anspruch 12, wobei die Einschuböffnungen (10, 10') an Ihren deckenseitigen Öffnungen Einführschrägen aufweisen.

14. Vorrichtung (1) gemäß einem der Ansprüche 9 bis 13, wobei die Vorrichtung (1) dazu eingerichtet ist, an der ersten Seitenfläche ein schmales Koppelelement (3) in die schmale Einführöffnung (100) einzuführen und an der zweiten Seitenfläche in die breite Einführöffnung (100') ein breites Koppelelement (3') einzuführen und wobei die Vorrichtung (1) weiterhin dazu eingerichtet ist, in die beiden breiten Einschuböffnungen (10) je einen breiten Leiterkartensteckverbinder (2) zur gemeinsamen Befestigung an dem schmalen Koppelelement (3) einzuschieben, um so die beiden breiten Leiterkartensteckverbinder (2) über das schmale Koppelelement (3) mechanisch reversibel miteinander zu verbinden,
und weiterhin in die beiden schmalen Einschuböffnungen (10') je einen schmalen Leiterkartensteckverbinder (2') zur gemeinsamen Befestigung an dem breiten Koppelelement (3') einzuschieben, um die beiden schmalen Steckverbinder (2') mechanisch reversibel miteinander zu verbinden.

15. Verfahren zur reversiblen gegenseitigen mechanischen Verbindung zumindest zweier Leiterkartensteckverbinder (2, 2') über zumindest ein Koppelelement (3, 3') zu zumindest einem Leiterkartensteckverbinderpaar mittels einer Vorrichtung (1) gemäß einem der Ansprüche 9 bis 14, aufweisend die folgenden Verfahrensschritte:
A. Einführen eines schmalen Koppelements (3) in die schmale Einführöffnung (100) und/oder eines breiten Koppelelements (3') in die breite Einführöffnung (100') der Vorrichtung;
B. Einschieben zweier breiter Leiterkartensteckverbinder (2) in jeweils eine der beiden breiten Einschuböffnungen (10) und/oder zweier schmaler Leiterkartensteckverbinder (2') in je eine der beiden schmalen Einschuböffnungen (10') der Vorrichtung;
C. gemeinsames reversibles Befestigen der beiden breiten Leiterkartensteckverbinder (2) an dem schmalen Koppelelement (3) und dadurch Verbinden zu einem breiten Leiterkartensteckverbinderpaar und/oder gemeinsames reversibles Befestigen der beiden schmalen Leiterkartensteckverbinder (2') an dem breiten Koppelelement (3') und dadurch Verbinden zu einem breiten Leiterkartensteckverbinderpaar;
D. Entnehmen des breiten und/oder schmalen Leiterkartensteckverbinderpaars aus der jeweiligen breiten (10) und/oder schmalen Einschuböffnung (10').

16. Verfahren gemäß Anspruch 15, wobei das Verfahren zusätzlich noch die folgenden Verfahrensschritte aufweist:
E. Einführen eines weiteren schmalen Koppelements (3) in die schmale Einführöffnung (100) und/oder eines weiteren breiten Koppelelements (3') in die breite Einführöffnung (100') der Vorrichtung (1);
F. Drehen des breiten und/oder des schmalen Leiterkartensteckverbinderpaars um 180°;
G. Einschieben des breiten und/oder des schmalen Leiterkartensteckverbinderpaars mit der dem an ihnen bereits verrasteten Koppelelement (3, 3') abgewandten Seite voran in die breiten (10) und/oder schmalen (10') Einschuböffnungen;
H. erneutes mechanisches gegenseitiges Verbinden der beiden breiten (2) und/oder der beiden schmalen (2') Leiterkartensteckverbinder über das jeweilige weitere schmale (3) und/oder breite (3') Koppelelement an ihrer zuvor noch unverbundenen Seite;
I. erneutes gemeinsames Entnehmen des nun beidseitig verbundenen breiten und/oder des nun beidseitig verbundenen schmalen Leiterkartensteckverbinderpaars aus den breiten und/oder schmalen Einschuböffnungen (10, 10') der Vorrichtung (1).

## Claims

1. Device (1), **characterized in that** the device serves for reversible mutual mechanical connection of at least two printed-circuit-board plug connectors (2, 2') via at least one coupling element (3, 3'),
wherein the device (1) has at least one insertion opening (100, 100') for insertion of the at least one coupling element (3, 3') in an insertion direction, and
wherein the device (1) furthermore has at least two push-in openings (10, 10') for pushing-in of the at least two printed-circuit-board plug connectors (2, 2') in a pushing-in direction,
wherein the at least one insertion opening (100, 100') is connected to two of the push-in openings (10, 10') to allow the at least one coupling element (3, 3') to be fixed mechanically to in each case two of the printed-circuit-board plug connectors (2, 2').

2. Device (1) according to Claim 1, wherein the insertion direction and the push-in direction are at a right angle to one another.

3. Device (1) according to either of the preceding claims, wherein the device (1) is of single-part form.

4. Device (1) according to either of Claims 1 and 2, wherein the device (1) is of multi-part form.

5. Device (1) according to one of the preceding claims, wherein the device (1) consists of plastic.

6. Device (1) according to Claim 5, wherein the device (1) is produced in an additive manufacturing process, such as for example 3D printing.

7. Device (1) according to Claim 5, wherein the device (1) is produced in an injection-moulding process.

8. Device (1) according to one of the preceding claims, wherein the device (1) has at least two insertion openings (100, 100'), specifically at least one narrow insertion opening (100) which is configured for insertion of a narrow coupling element (3) and is arranged at a first side surface of the device (1), and furthermore at least one wide insertion opening (100') which is configured for insertion of a wide coupling element (3') and is arranged at a second side surface of the device (1).

9. Device (1) according to Claim 8, wherein the device (1) has at least four push-in openings (10, 10'), specifically at least two wide push-in openings (10) which are arranged at the first side surface and are connected to the at least one narrow insertion opening (100), and furthermore at least two narrow push-in openings (10') which are arranged at the second side surface and are connected to the at least one narrow insertion opening (100').

10. Device (1) according to Claim 9, wherein the device (1) has a base plate (12) and a guide body (14), wherein the guide body (14) is constructed on the base plate (12), and wherein said first side surface and said second side surface are a constituent part of the guide body (14).

11. Device (1) according to Claim 10, wherein the guide body (14) has a substantially cuboidal basic shape.

12. Device (1) according to either of Claims 10 and 11, wherein the push-in openings (10, 10') are open towards a ceiling surface (16), directed away from the base plate (12), of the guide body (14), that is to say at the ceiling side.

13. Device (1) according to Claim 12, wherein the push-in openings (10, 10') have insertion bevels at their ceiling-side openings.

14. Device (1) according to one of Claims 9 to 13, wherein the device (1) is configured for insertion of a narrow coupling element (3) into the narrow insertion opening (100) at the first side surface and for insertion of a wide coupling element (3') into the wide insertion opening (100') at the second side surface, and wherein the device (1) is furthermore configured for pushing-in of in each case one wide printed-circuit-board plug connector (2) into the two wide push-in openings (10) for joint fastening to the narrow coupling element (3), in order in this way for the two wide printed-circuit-board plug connectors (2) to be connected to one another in a mechanically reversible manner via the narrow coupling element (3), and furthermore for pushing-in of in each case one narrow printed-circuit-board plug connector (2') into the two narrow push-in openings (10') for joint fastening to the wide coupling element (3'), in order for the two narrow plug connectors (2') to be connected to one another in a mechanically reversible manner.

15. Method for reversible mutual mechanical connection of at least two printed-circuit-board plug connectors (2, 2') via at least one coupling element (3, 3') to form at least one printed-circuit-board-plug-connector pair by means of a device (1) according to one of Claims 9 to 14, comprising the following method steps:
A. inserting a narrow coupling element (3) into the narrow insertion opening (100), and/or a wide coupling element (3') into the wide insertion opening (100'), of the device;
B. pushing two wide printed-circuit-board plug connectors (2) into in each case one of the two wide push-in openings (10), and/or two narrow printed-circuit-board plug connectors (2') into in each case one of the two narrow push-in openings (10'), of the device;
C. jointly reversibly fastening the two wide printed-circuit-board plug connectors (2) to the narrow coupling element (3) and consequently connecting them to form a wide printed-circuit-board-plug-connector pair, and/or jointly reversibly fastening the two narrow printed-circuit-board plug connectors (2') to the wide coupling element (3') and consequently connecting them to form a wide printed-circuit-board-plug-connector pair;
D. removing the wide and/or narrow printed-circuit-board-plug-connector pair from the respective wide (10) and/or narrow push-in opening (10').

16. Method according to Claim 15, wherein the method additionally comprises the following method steps:
E. inserting a further narrow coupling element (3) into the narrow insertion opening (100), and/or a further wide coupling element (3') into the wide insertion opening (100'), of the device (1);
F. turning the wide and/or narrow printed-circuit-board-plug-connector pair through 180°;
G. pushing the wide and/or narrow printed-circuit-board-plug-connector pair into the wide (10) and/or narrow (10') push-in openings with the side which is directed away from the coupling element (3, 3') already latched thereto at the front;
H. mechanically connecting the two wide (2) and/or two narrow (2') printed-circuit-board plug connectors to one another again at their side still unconnected beforehand via the respective further narrow (3) and/or wide (3') coupling element;
I. jointly removing the wide and/or narrow printed-circuit-board-plug-connector pair, now connected at both sides, from the wide and/or narrow push-in openings (10, 10') of the device (1) again.

## Revendications

1. Dispositif (1), **caractérisé en ce que** le dispositif sert à la connexion mécanique mutuelle réversible d'au moins deux connecteurs enfichables de carte de circuit imprimé (2, 2') par l'intermédiaire d'au moins un élément de couplage (3, 3'),
le dispositif (1) possédant au moins une ouverture d'introduction (100, 100') pour l'introduction de l'au moins un élément de couplage (3, 3') dans une direction d'introduction, et
le dispositif (1) présentant en outre au moins deux ouvertures d'insertion (10, 10') pour l'insertion des au moins deux connecteurs enfichables de carte de circuit imprimé (2, 2°) dans une direction d'insertion,
l'au moins une ouverture d'introduction (100, 100') étant reliée à deux des ouvertures d'insertion (10, 10') afin de permettre une fixation mécanique de l'au moins un élément de couplage (3, 3') sur respectivement deux des connecteurs enfichables de carte de circuit imprimé (2, 2').

2. Dispositif (1) selon la revendication 1, la direction d'introduction et la direction d'insertion étant perpendiculaires l'une à l'autre.

3. Dispositif (1) selon l'une quelconque des revendications précédentes, le dispositif (1) étant réalisé en une partie.

4. Dispositif (1) selon l'une quelconque des revendications 1 à 2, le dispositif (1) étant réalisé en plusieurs parties.

5. Dispositif (1) selon l'une quelconque des revendications précédentes, le dispositif (1) étant constitué de matière plastique.

6. Dispositif (1) selon la revendication 5, le dispositif (1) étant fabriqué par un procédé de fabrication additive, tel que p. ex. l'impression 3D.

7. Dispositif (1) selon la revendication 5, le dispositif (1) étant fabriqué par un procédé de moulage par injection.

8. Dispositif (1) selon l'une quelconque des revendications précédentes, le dispositif (1) présentant au moins deux ouvertures d'introduction (100, 100'), à savoir au moins une ouverture d'introduction étroite (100) adaptée à l'introduction d'un élément de couplage étroit (3), qui est agencée sur une première surface latérale du dispositif (1), et en outre au moins une ouverture d'introduction large (100') adaptée à l'introduction d'un élément de couplage large (3'), qui est agencée sur une deuxième surface latérale du dispositif (1).

9. Dispositif (1) selon la revendication 8, le dispositif (1) présentant au moins quatre ouvertures d'insertion (10, 10'), à savoir au moins deux ouvertures d'insertion larges (10) agencées sur la première surface latérale et en connexion avec l'au moins une ouverture d'introduction étroite (100), et en outre au moins deux ouvertures d'insertion étroites (10') agencées sur la deuxième surface latérale et en connexion avec l'au moins une ouverture d'introduction étroite (100').

10. Dispositif (1) selon la revendication 9, le dispositif (1) possédant une plaque de base (12) et un corps de guidage (14), le corps de guidage (14) étant construit sur la plaque de base (12), et ladite première surface latérale et ladite deuxième surface latérale faisant partie du corps de guidage (14).

11. Dispositif (1) selon la revendication 10, le corps de guidage (14) possédant une forme de base essentiellement parallélépipédique.

12. Dispositif (1) selon l'une quelconque des revendications 10 à 11, les ouvertures d'insertion (10, 10') étant ouvertes vers une surface de plafond (16) du corps de guidage (14) détournée de la plaque de base (12), donc côté plafond.

13. Dispositif (1) selon la revendication 12, les ouvertures d'insertion (10, 10') présentent des biais d'introduction au niveau de leurs ouvertures côté plafond.

14. Dispositif (1) selon l'une quelconque des revendications 9 à 13, le dispositif (1) étant adapté pour introduire un élément de couplage étroit (3) dans l'ouverture d'introduction étroite (100) sur la première surface latérale et un élément de couplage large (3') dans l'ouverture d'introduction large (100') sur la deuxième surface latérale, et le dispositif (1) étant en outre adapté pour insérer dans chacune des deux ouvertures d'insertion larges (10) un connecteur enfichable de carte de circuit imprimé large (2) pour la fixation commune à l'élément de couplage étroit (3), afin de connecter ainsi mécaniquement de manière réversible les deux connecteurs enfichables de carte de circuit imprimé larges (2) entre eux par l'intermédiaire de l'élément de couplage étroit (3),
et en outre pour insérer dans chacune des deux ouvertures d'insertion étroites (10') un connecteur enfichable de carte de circuit imprimé étroit (2°) pour la fixation commune à l'élément de couplage large (3'), afin de connecter mécaniquement de manière réversible les deux connecteurs enfichables étroits (2) entre eux.

15. Procédé de connexion mécanique mutuelle réversible d'au moins deux connecteurs enfichables de carte de circuit imprimé (2, 2') par l'intermédiaire d'au moins un élément de couplage (3, 3') en au moins une paire de connecteurs enfichables de carte de circuit imprimé au moyen d'un dispositif (1) selon l'une quelconque des revendications 9 à 14, présentant les étapes de procédé suivantes :
A. l'introduction d'un élément de couplage étroit (3) dans l'ouverture d'introduction étroite (100) et/ou d'un élément de couplage large (3') dans l'ouverture d'introduction large (100') du dispositif ;
B. l'insertion de deux connecteurs enfichables de carte de circuit imprimé larges (2) dans respectivement l'une des deux ouvertures d'insertion larges (10) et/ou de deux connecteurs enfichables de carte de circuit imprimé étroits (2') dans respectivement l'une des deux ouvertures d'insertion étroites (10') du dispositif ;
C. la fixation commune réversible des deux connecteurs enfichables de carte de circuit imprimé larges (2) à l'élément de couplage étroit (3) et ainsi la connexion en une paire de connecteurs enfichables de carte de circuit imprimé larges et/ou la fixation commune réversible des deux connecteurs enfichables de carte de circuit imprimé étroits (2') à l'élément de couplage large (3°) et ainsi la connexion en une paire de connecteurs enfichables de carte de circuit imprimé larges,
D. le retrait de la paire de connecteurs enfichables de carte de circuit imprimé larges et/ou étroits de l'ouverture d'insertion large (10) et/ou étroite (107) respective.

16. Procédé selon la revendication 15, le procédé présentant en outre encore les étapes de procédé suivantes :
E. l'introduction d'un autre élément de couplage étroit (3) dans l'ouverture d'insertion étroite (100) et/ou d'un autre élément de couplage large (3') dans l'ouverture d'insertion large (100°) du dispositif (1) ;
F. la rotation de 180° de la paire de connecteurs enfichables de carte de circuit imprimé large et/ou étroite ;
G. l'insertion de la paire de connecteurs enfichables de carte de circuit imprimé large et/ou étroite dans les ouvertures d'insertion large (10) et/ou étroite (10'), avec le côté détourné de l'élément de couplage (3, 3') déjà enclenché sur eux en avant ;
H. la nouvelle connexion mécanique mutuelle des deux connecteurs enfichables de carte de circuit imprimé larges (2) et/ou des deux connecteurs enfichables de carte de circuit imprimé étroits (2') par l'intermédiaire de l'autre élément de couplage étroit (3) et/ou large (3') respectif sur leur côté encore non connecté auparavant ;
I. le nouveau retrait conjoint de la paire de connecteurs enfichables de carte de circuit imprimé large, maintenant reliée des deux côtés, et/ou de la paire de connecteurs enfichables de carte de circuit imprimé étroite, maintenant reliée des deux côtés, des ouvertures d'insertion larges et/ou étroites (10, 10') du dispositif (1).
